# FASCICULE DE BREVET EUROPEEN

(11) **EP 0 794 612 B1**
(45) Date de publication et mention de la délivrance du brevet: **02.01.2003**
(21) Numéro de dépôt: 97400478.0
(22) Date de dépôt: 03.03.1997
(51) Int. Cl.: H03D 11/00, H04B 1/30, H04B 15/04

(54) **Procédé de fonctionnement d'au moins un récepteur de signaux radioélectrique placé dans le voisinage d'un organe ou appareillage rayonnant**
Verfahren der Funktion eines Funkempfängers in der Nähe eines strahlenden Gerätes
Method of operation for a radio receiver operated close to an interfering apparatus

(30) Priorité: 04.03.1996 FR 9602676
(43) Date de publication de la demande: 10.09.1997
(73) Titulaire: ATRAL, F-38190 Crolles (FR)
(72) Inventeur: Morey, Gilles, 38330 Saint-Ismier (FR)
(74) Mandataire: Casalonga, Axel

(56) Documents cités:
- EP-A- 0 553 862
- US-A- 3 746 999

## Description

La présente invention concerne le domaine des récepteurs de signaux radioélectriques.

Le document US-A-3 746 999 propose un récepteur à super-réaction dans lequel la fréquence quench varie en fonction de la détection d'une modulation provenant d'une source extérieure. Cette variation ne permet pas d'éviter totalement les interférences puisque cette source est suceptible de perturber à nouveau, ultérieurement, ledit récepteur.

Le document EP-A-553 862 propose un dispositif électronique qui comprend une unité de calcul et une unité émettrice/réceptrice, dans lequel, selon un premier état, l'unité émettrice/réceptrice est en continu en veille et l'unité de calcul est en fonctionnement et, selon un second état dont le démarrage se produit à un moment aléatoire, l'unité de calcul est mise à l'état de repos lorsque l'unité émettrice/réceptrice reçoit un signal, et ce jusqu'à la fin de la réception de ce signal.

Le but de la présente invention est d'améliorer la capacité de réception des récepteurs de signaux radioélectriques, afin que la réception, l'analyse ou l'interprétation des signaux radioélectriques qu'ils attendent soient améliorées.

La présente invention tel que définie à la revendication 1 concerne un procédé de fonctionnement d'au moins un récepteur de signaux radioélectriques, en particulier un récepteur superhétérodyne ou un récepteur à super-réaction, susceptible d'être disposé dans le champ électromagnétique d'au moins un moyen rayonnant d'un organe ou appareillage, en particulier un organe ou appareillage électrique, électronique ou électromécanique n'ayant pas vocation d'émettre.

Lesdits organes ou appareillages peuvent être en particulier constitués par des commutateurs, pris dans leur sens général, tels que microprocesseurs, transistors, triacs, thyristors, relais ou tout autre organe appartenant à un circuit électrique ou électronique ou une installation, notamment lorsqu'ils fonctionnent ou rayonnent par impulsions périodiques.

Lesdits organes ou appareillages peuvent être constitués également par des récepteurs à super-réaction, ces derniers présentant la particularité de rayonner une énergie électromagnétique sur leur fréquence nominale par leur antenne. Le but de l'invention est, dans ce cas particulier, de faire cohabiter deux ou plusieurs récepteurs sur la même fréquence nominale ou des fréquences nominales proches, sans que ces récepteurs ne s'aveuglent ou ne se perturbent mutuellement. La présente invention peut également être utilisée en cas de couplage par conduction ou induction entre un récepteur et un organe générateur de parasites sur la fréquence nominale de ce récepteur ou sur sa fréquence intermédiaire.

La présente invention se rapporte donc à un procédé de fonctionnement d'au moins un récepteur de signaux radioélectriques susceptible d'être disposé dans le champ électromagnétique d'au moins un moyen rayonnant d'un organe ou appareillage, en particulier un organe ou appareillage électrique, électronique ou électromécanique, à une distance telle que ledit récepteur est capable de détecter ou d'être sensible à ce champ électromagnétique rayonné notamment sur sa fréquence nominale de réception.

Le procédé selon l'invention consiste à soumettre ledit récepteur à un signal d'horloge déterminant des phases séquentielles et/ou périodiques temporellement espacées d'écoute ou de sensibilité, à soumettre ledit moyen rayonnant à un signal d'horloge déterminant des phases séquentielles et/ou périodiques temporellement espacées de fonctionnement ou de rayonnement, et à disjoindre temporellement les phases séquentielles et/ou périodiques d'écoute ou de sensibilité dudit récepteur par rapport aux phases séquentielles et/ou périodiques de fonctionnement ou de rayonnement dudit moyen rayonnant, en synchronisant le signal d'horloge du récepteur et le signal d'horloge du moyen rayonnant, de telle sorte que, pendant les phases d'écoute ou de sensibilité dudit récepteur, ledit moyen rayonnant est dans ses phases séquentielles et/ou périodiques de non fonctionnement ou de non rayonnement.

Selon une application de l'invention, le récepteur de signaux radioélectriques comprend une antenne, un oscillateur-détecteur à super-réaction et des moyens pour fixer des périodes composées de séquences de blocage-déblocage de cet oscillateur-détecteur afin de rendre sensible cet oscillateur-détecteur à l'énergie reçue sur une fréquence nominale de réception (f1), ledit oscillateur détecteur présentant, dans chacune desdites périodes, une phase de sensibilité (A) suivie d'une phase de montée en amplitude ou d'amplitude accrue (B, C) puis de décroissance (D) de ses oscillations.

Selon l'invention, le procédé peut alors consiter à disjoindre temporellement la phase de sensibilité (A) de l'oscillateur-détecteur dudit récepteur par rapport à la phase de fonctionnement ou de rayonnement dudit moyen rayonnant en inhibant, bloquant ou stoppant le processus de fonctionnement ou de rayonnement dudit moyen rayonnant pendant la phase de sensibilité (A) de l'oscillateur-détecteur dudit récepteur.

Selon une autre application de l'invention, le récepteur de signaux radioélectriques comprend une antenne, un oscillateur-détecteur à super-réaction et des moyens pour fixer des périodes composées de séquences de blocage-déblocage de cet oscillateur-détecteur afin de rendre sensible cet oscillateur-détecteur à l'énergie reçue sur une fréquence nominale de réception (f1), ledit oscillateur-détecteur présentant, dans chacune desdites périodes, une phase de sensibilité (A) suivie d'une phase de montée en amplitude ou d'amplitude accrue (B, C) puis de décroissance (D) de ses oscillations.

Selon l'invention, le procédé peut alors consiter à détecter le rayonnement électromagnétique dudit moyen rayonnant ; et à disjoindre temporellement la phase de sensibilité (A) de l'oscillateur-détecteur dudit récepteur par rapport à la phase de fonctionnement ou de rayonnement dudit moyen rayonnant en décalant temporellement les phases précitées de fonctionnement ou de rayonnement dudit moyen rayonnant d'une valeur de temps prédéterminée.

Selon une autre application de l'invention, le récepteur de signaux radioélectriques comprenant une antenne, un oscillateur-détecteur à super-réaction et des moyens pour fixer des périodes composées de séquences de blocage-déblocage de cet oscillateur-détecteur afin de rendre sensible cet oscillateur-détecteur à l'énergie reçue sur une fréquence nominale de réception (f1), ledit oscillateur-détecteur présentant, dans chacune desdites périodes, une phase de sensibilité (A) suivie d'une phase de montée en amplitude ou d'amplitude accrue (B, C) puis de décroissance (D) de ses oscillations.

Selon l'invention, le procédé peut alors consiter à comparer au moins une caractéristique des signaux radioélectriques reçus par ledit récepteur à une caractéristique correspondante d'un signal attendu, et à disjoindre temporellement la phase de sensibilité (A) de l'oscillateur-détecteur dudit récepteur par rapport à la phase de fonctionnement ou de rayonnement dudit moyen rayonnant en fournissant auxdits moyens pour fixer des périodes composées de séquences de blocage-déblocage un ordre de décalage, d'une valeur de temps déterminée, desdites périodes au cas où ces caractéristiques comparées sont différentes.

Selon une autre application de l'invention, ledit récepteur et ledit moyen rayonnant sont deux récepteurs de signaux radioélectriques comprenant respectivement une antenne, un oscillateur-détecteur à super-réaction et des moyens pour fixer des périodes composées de séquences de blocage-déblocage de cet oscillateur-détecteur afin de rendre sensible ces oscillateur-détecteur à l'énergie reçue sur une fréquence nominale de réception commune (f1) ou sur deux fréquences proches, lesdits oscillateurs-détecteurs présentant respectivement, dans chacune desdites périodes, une phase de sensibilité (A) suivie d'une phase de montée en amplitude ou d'amplitude accrue (B, C) puis de décroissance (D) de ses oscillations, lesdits récepteurs étant susceptibles d'être disposés à une distance telle qu'au moins l'un desdits récepteurs est capable de détecter ou d'être sensible au champ électromagnétique susceptible d'être émis par l'autre.

Selon l'invention, le procédé peut alors consiter à disjoindre temporellement les phases de sensibilité (A) de l'oscillateur-détecteur de l'un desdits récepteurs des phases précitées de montée en amplitude ou d'amplitude accrue (B, C) puis de décroissance (D) des oscillations de l'oscillateur-détecteur de l'autre récepteur, en faisant osciller les oscillateurs-détecteurs desdits récepteurs selon des périodes composées de séquences de blocage-déblocage simultanées ou synchrones ou identiques, de telle sorte que l'un des récepteurs, pendant la phase de sensibilité de son oscillateur-détecteur, ne détecte pas l'énergie électromagnétique susceptible d'être rayonnée par l'autre récepteur sur ladite fréquence nominale ou lesdites fréquences proches.

Selon l'invention, le procédé peut avantageusement consiter à soumettre les oscillateurs-détecteurs desdits récepteurs à une horloge commune déterminant lesdites séquences d'oscillations de l'oscillateur-détecteur de ces récepteurs.

Selon l'invention, le procédé peut avantageusement à comparer au moins une caractéristique des signaux radioélectriques reçus par ledit récepteur à une caractéristique correspondante d'un signal attendu, et à disjoindre temporellement la phase d'écoute ou de sensibilité dudit récepteur par rapport à la phase de fonctionnement ou de rayonnement dudit moyen rayonnant en décalant lesdites phases temporellement espacées d'écoute ou de sensibilité dudit récepteur, d'une valeur de temps déterminée, au cas où lesdites caractéristiques comparées sont différentes.

Selon l'invention, le procédé peut avantageusement consiter à soumettre ledit moyen rayonnant après réception par ledit récepteur d'un signal attendu à des phases temporellement espacées de fonctionnement ou de rayonnement, à comparer au moins une caractéristique des signaux radioélectriques reçus par ledit récepteur à une caractéristique correspondante d'un signal attendu, et à disjoindre temporellement la phase d'écoute ou de sensibilité dudit récepteur par rapport à la phase de fonctionnement ou de rayonnement dudit moyen rayonnant en modifiant la durée desdites phases temporellement espacées d'écoute ou de sensibilité dudit récepteur et, corrélativement, à disjoindre lesdites phases de fonctionnement ou de rayonnement dudit moyen rayonnant, d'une valeur de temps déterminée, au cas où lesdites caractéristiques comparées sont identiques.

Selon l'invention, le procédé peut avantageusement consiter à effectuer ladite modification de la durée desdites phases d'écoute ou de sensibilité dudit récepteur en prolongeant, d'une valeur de temps déterminée, la durée de la phase au cours de laquelle lesdites caractéristiques comparées sont identiques.

Selon l'invention, le procédé peut avantageusement consiter, après réception par ledit récepteur d'un signal attendu, à soumettre ledit moyen rayonnant à des phases temporellement espacées de fonctionnement ou de rayonnement dépendant du contenu dudit signal reçu par ledit récepteur et à soumettre ledit récepteur à des phases temporellement espacées d'écoute ou de sensibilité dépendant également du contenu dudit signal reçu par ledit récepteur.

Selon l'invention, le procédé peut avantageusement consiter à soumettre ledit moyen rayonnant, tel qu'un triac, à des phases temporellement espacées de fonctionnement ou de rayonnement, ces phases consistant en des impulsions ou signaux périodiques de déclenchement ou de fonctionnement de ce moyen.

Selon l'invention, le procédé consiter lesdites impulsions peuvent avantageusement être en relation avec les périodes d'une source d'énergie électrique alternative.

La présente invention sera mieux comprise à l'étude de récepteurs de signaux radioélectriques et de leur fonctionnement, décrits à titre d'exemples non limitatifs et illustrés par le dessin sur lequel :
- la figure 1 représente un schéma d'un récepteur comprenant un oscillateur-détecteur à super-réaction ;
- la figure 2 représente un schéma de fonctionnement de ce récepteur à super-réaction ;
- la figure 3 représente un premier mode de réalisation de récepteurs selon la présente invention ;
- la figure 4 représente un second mode de réalisation d'un récepteur selon la présente invention ;
- la figure 5 représente un troisième mode de réalisation d'un récepteur selon la présente invention ;
- la figure 6 représente un autre mode de réalisation d'un récepteur selon la présente invention ;
- la figure 7 représente un mode de réalisation d'un récepteur adapté à un variateur selon la présente invention ;
- et la figure 8 représente un mode de fonctionnement du variateur de la figure 7.

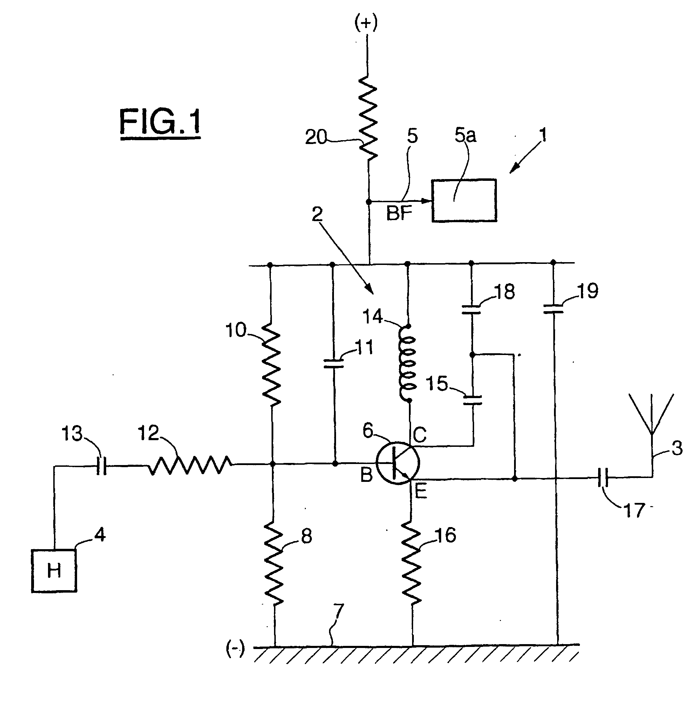

En se reportant à la figure 1, on voit que le récepteur de signaux radioélectriques représenté, repéré d'une manière générale par la référence 1, comprend un oscillateur-détecteur à super-réaction, repéré d'une manière générale par la référence 2, relié à une antenne 3 de réception d'ondes électromagnétiques, recevant des signaux successifs de blocage-déblocage d'une horloge de séquencement 4 lui permettant d'osciller sur sa fréquence nominale de réception f1 périodiquement pendant des séquences d'oscillations d'une durée déterminée et fournissant sur un point de sortie 5 un signal basse fréquence BF dirigé vers un organe de traitement 5a.

Dans l'exemple représenté, l'oscillateur-détecteur 2 comprend un élément actif constitué par un transistor 6 dont la base est reliée au pôle (-) d'une alimentation ou masse 7 par l'intermédiaire d'une résistance 8, au point 5 via une résistance 10 et une capacité 11 en parallèle, et à l'horloge 4 via une résistance 12 et une capacité 13.

Le collecteur du transistor 6 est relié au point 5 par l'intermédiaire d'une self 14 constituant un élément réactif, et à son émetteur par l'intermédiaire d'une capacité de réaction 15.

L'émetteur du transistor 6 est relié au pôle (-) via une résistance 16, à l'antenne 3 via une capacité 17 et au point 5 par une capacité 18 d'adaptation d'impédance.

Une capacité de filtrage 19 relie le point 5 à la masse 7.

Le point 5 est relié au pôle (+) de l'alimentation au travers d'une résistance 20, la détection de la modulation basse fréquence (BF) se faisant par extraction de la variation du courant moyen consommé par l'étage oscillateur-détecteur 2.

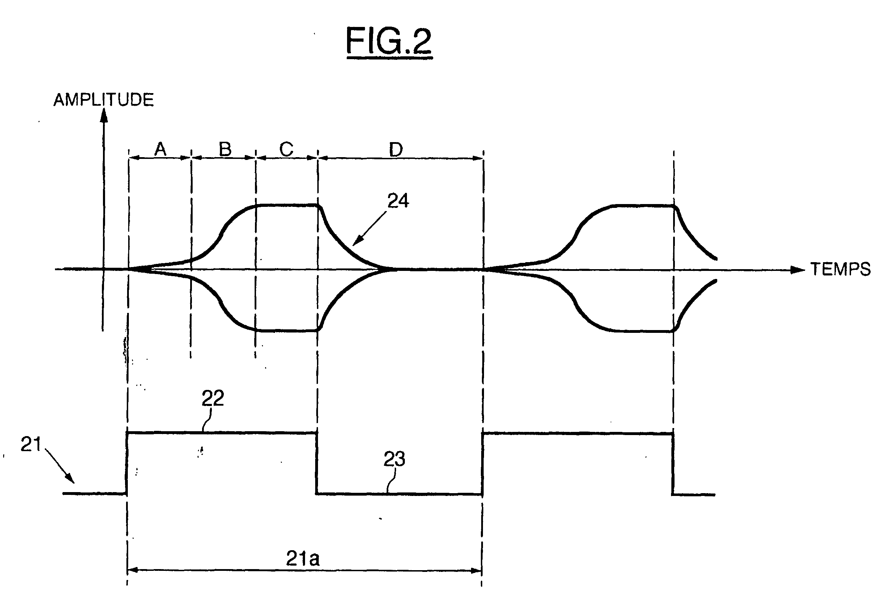

En se reportant à la figure 2 on voit qu'on a représenté un diagramme général de fonctionnement du récepteur 1 de la figure 1.

Sur cette figure 2, on voit qu'on a représenté la forme d'un signal de commande en créneaux 21 déterminant des périodes 21a de blocage-déblocage de l'oscillateur-détecteur 2. Ce signal est fourni par l'horloge 4 qui fixe dans chaque période 21a, cycliquement, des séquences de déblocage 22 suivies de séquences de blocage 23 de cet oscillateur-détecteur 2.

En correspondance avec le signal d'horloge 21, on a également représenté sur la figure 2 une courbe enveloppe particulière, répérée d'une manière générale par la référence 24, de l'amplitude des oscillations de l'oscillateur-détecteur 2 en mode logarythmique.

On voit que cette courbe 24 comprend dans chaque séquence de déblocage 22 de l'oscillateur-détecteur 2 une phase A de sensibilité, suivie d'une phase B de croissance de l'amplitude des oscillations de l'oscillateur-détecluer 2, suivie d'une phase C de stabilisation de cette amplitude et suivie, dans la séquence de blocage 23, d'une phase D de chute progressive et rapide de cette amplitude. La phase C pourrait ne pas exister et, en mode de détection dit linéaire non représenté, la phase D interviendrait avant la fin de la phase B.

Comme l'antenne 3 est reliée à l'oscillateur-détecteur 2, les phases d'oscillations B, C et D génèrent par cette antenne une énergie électromagnétique qui rayonne autour de cette dernière jusqu'à une distance déterminée, le rayonnement lors de la phase de sensibilité A étant très faible et pour ainsi dire négligeable.

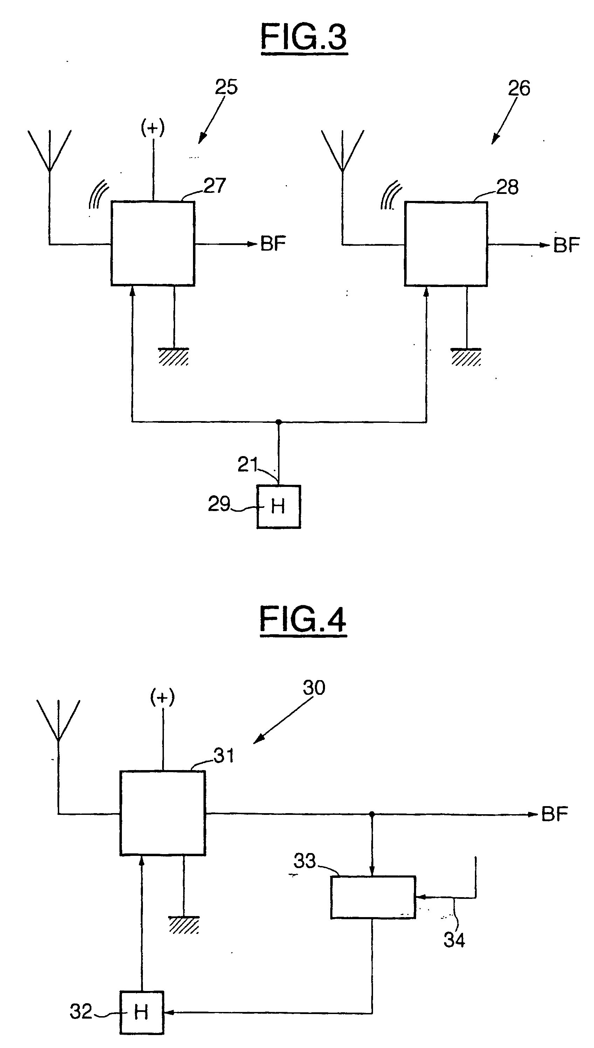

En se reportant à l'exemple représenté sur la figure 3, on voit qu'on a représenté deux récepteurs de signaux radioélectriques 25 et 26 par exemple identiques au récepteur 1 de la figure 1, comprenant des oscillateurs-détecteurs identiques 27 et 28, qui sont soumis au même signal d'horloge 21 fourni par une horloge commune de séquencement 29, qui détermine les périodes successives 21a et, dans ces périodes, le début et la durée des séquences 22 et 23 précitées, ces séquences étant en conséquence simultanées, synchrones ou identiques pour chacun des récepteurs.

Ainsi, les phases de sensibilité A des oscillateurs-détecteurs des récepteurs 25 et 26 se produisent sensiblement simultanément, de même que les phases B, C et D à amplitude accrue.

Il en résulte que les phases B, C et D à amplitude accrue de l'un des récepteurs 26 ou 27, qui provoque une énergie électromagnétique perturbatrice émise par son antenne, ne se produisent pas simultanément à la phase de sensibilité A de l'autre récepteur, de telle sorte que les récepteurs 25 et 26 ne peuvent pas se perturber mutuellement même s'ils se trouvent dans le champ électromagnétique qu'ils émettent pendant leur phase B, C et D. En d'autres termes, les phases périodiques de sensibilité A de l'un desdits récepteurs à super-réaction sont disjointes des phases B, C et D à amplitude accrue de l'autre récepteur à super-réaction.

Dans une application particulière, il devient ainsi possible d'écouter une large bande de fréquences en mettant en parallèle plusieurs récepteurs à super-réaction accordés sur des fréquences de réception contigues ou proches et commandés en synchronisme par une horloge commune sans que ceux-ci ne se perturbent mutuellement. L'ensemble de ces récepteurs peut constituer avantageusement un système de surveillance d'une large bande de fréquence.

En se reportant à un autre exemple représenté sur la figure 4, on voit qu'on a représenté un récepteur 30 de signaux radioélectriques comprenant un oscillateur-détecteur 31, correspondant à celui de la figure 1, et une horloge de séquencement 32.

Ce récepteur comprend en outre un organe de traitement 33 qui reçoit les signaux de sortie BF de l'oscillateur-détecteur 31. Cet organe de traitement 33 comprend un comparateur qui permet de comparer au moins une caractéristique des signaux BF reçus à une caractéristique correspondante, par exemple la forme, d'un signal de référence 34, en particulier un signal attendu.

Si ces caractéristiques comparées sont différentes, cet organe 33 fournit un ordre de décalage dans le temps qui est dirigé vers l'horloge 32.

Dans une variante, l'organe de traitement 33 pourrait avantageusement ne fournir cet ordre de commande qu'après avoir constaté la présence d'un signal non attendu dans les signaux reçus dans un nombre prédéterminé de séquences successives 22 et 23 d'oscillations de l'oscillateur-détecteur 31, par exemple trois.

A la réception dudit ordre de décalage, l'horloge 32 décale d'une valeur de temps prédéterminée en avant ou en arrière les séquences 22 et 23 de blocage-déblocage de son oscillateur-détecteur 31, cette valeur correspondant de préférence à une fraction de la durée des séquences 22 et 23.

Ces signaux reçus mais non attendus peuvent être d'origines très différentes. Ils peuvent provenir d'organes ou appareillages voisins non représentés comprenant au moins un moyen fonctionnant par impulsions périodiques générant un champ électromagnétique, ces organes étant placés à une distance du récepteur 30 telle que ledit récepteur 30 est capable de détecter ou est sensible à ce champ électromagnétique perturbateur.

A la suite d'un ou éventuellement de quelques décalages de l'horloge 32, les phases de sensibilité A de l'oscillateur-détecteur 31 arrivent à se trouver disjointes des phases de rayonnement desdits organes ou appareillages voisins de telle sorte que le récepteur 30 n'est plus perturbé par le champ électromagnétique rayonné par ces organes ou appareillages. Bien entendu, si une nouvelle perturbation est détectée, le processus de décalage précité se reproduit.

Dans un exemple particulier, les signaux reçus mais non attendus peuvent provenir d'un récepteur à super-réaction non représenté, voisin, identique ou similaire au récepteur 30, qui émet sur une fréquence identique ou proche et selon un séquencement identique ou proche une énergie électromagnétique par son antenne due aux phases B, C et D précitées de son oscillateur-détecteur, ce récepteur 30 et ce récepteur voisin étant placés à une distance telle que l'énergie électromagnétique émise par l'antenne de l'un est susceptible d'être captée par l'autre.

Dans ce cas, l'organe de traitement 33 transmet un ordre de décalage dans le temps du signal d'horloge 21 fourni par l'horloge 32 de ce récepteur 30, d'une valeur déterminée, par exemple égale à un dixième de la durée de sa période 21a. Il s'ensuit que la phase de sensibilité A du récepteur 31 glisse dans le temps par rapport à la phase de sensibilité A dudit récepteur voisin.

Par répétition de ces glissements dans le temps dus à la détection du signal non attendu provenant dudit récepteur voisin dans des séquences successives du détecteur 30, il arrive un moment où la phase de sensibilité A du récepteur 31 et la phase de sensibilité A dudit récepteur voisin sont simultanées ou presque simultanées. Alors, le récepteur 30 et ledit récepteur voisin ne se pertubent pas mutuellement et leurs fonctionnements correspondent à ceux décrits en référence à la figure 3, sans horloge commune, leurs phases de sensibilité et leur phase d'oscillation à amplitude accrue étant disjointes.

L'exemple ci-dessus est donc bien adapté pour insensibiliser les uns par rapport aux autres des récepteurs 30 indépendants ayant chacun leur propre horloge de séquencement.

- Dans d'autres exemples, l'organe ou appareillage voisin du récepteur 30 et rayonnant par impulsions périodiques un champ électromagnétique pourrait être un commutateur électrique ou électronique tel qu'un microprocesseur, un transistor, un triac, un thyristor, un relais ou tout autre organe électrique, électronique ou électromécanique n'ayant pas vocation d'émettre.

A la réception de signaux électromagnétiques perturbateurs émis par ces organes, le récepteur 30 fonctionnerait comme décrit précédemment pour provoquer un ou plusieurs décalages du séquencement du fonctionnement de son oscillateur-détecteur 31 par décalage de l'horloge 32, jusqu'à disparition de l'effet sur le récepteur 30 de leur champ pertubateur.

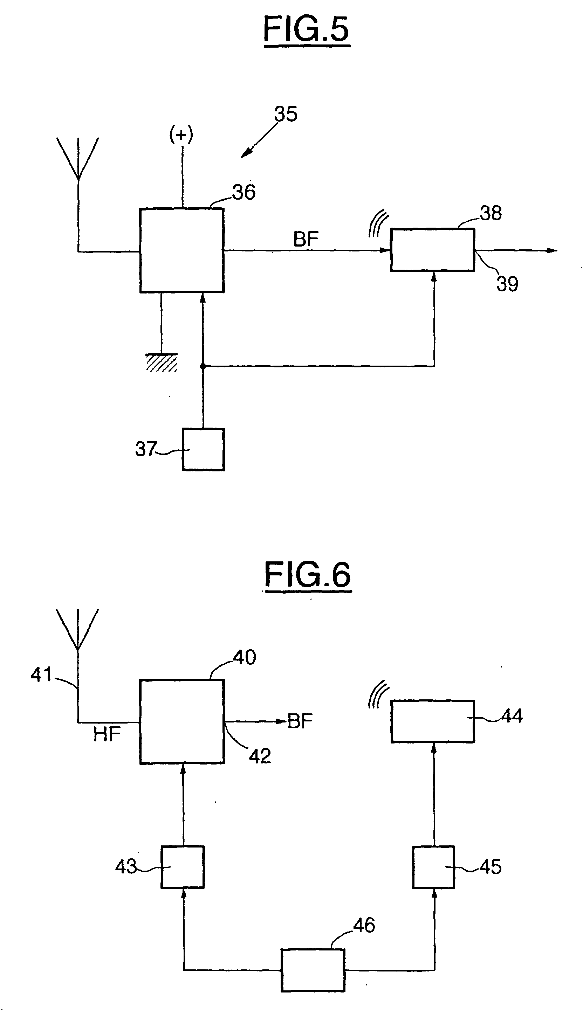

En se reportant à un autre exemple représenté sur la figure 5, on voit qu'on a représenté un récepteur 35 comprenant un oscillateur-détecteur 36 et une horloge de séquencement 37, associé à un circuit électrique ou électronique 38 en particulier de traitement du signal BF délivré par cet oscillateur-détecteur 36, ce circuit 38 pouvant être un microprocesseur délivrant un signal d'ordre à sa sortie 39.

L'horloge 37 est avantageusement reliée au microprocesseur 38 et délivre à celui-ci un signal tel que ce microprocesseur 38 se bloque ou stoppe son fonctionnement pendant la phase de sensibilité A de l'oscillateur-détecteur 36, par exemple en arrêtant son horloge interne, c'est-à-dire n'autorise le fonctionnement de ce microprocesseur 38 qu'uniquement en dehors de cette phase de sensibilité A.

Ainsi, le champ électromagnétique perturbateur, rayonné ou conduit, qu'émet le microprocesseur 38 pendant les phases B, C et D d'oscillation de l'oscillateur-détecteur 36 du récepteur 35 n'est pas susceptible de perturber le signal reçu par ce récepteur et attendu, les phases successives de sensibilité A de l'oscillateur-détecteur 36 étant en conséquence disjointes des phases de fonctionnement du microprocesseur 38.

Dans d'autres exemples, l'horloge 37 pourrait émettre un signal de blocage ou de temporisation ou de décalage du processus de fonctionnement à tous autres moyens ou organes 38 qui seraient reliés ou reliables électriquement au récepteur 35, tels qu'un transistor, un triac, un thyristor, un relais ou tout autre circuit électrique ou de traitement électronique n'ayant pas vocation d'émettre, afin que leurs phases de fonctionnement soient disjointes des phases successives de sensibilité A de l'oscillateur-détecteur 36.

En se reportant l'exemple de la figure 6, on voit qu'on a représenté un récepteur de signaux radioélectriques 40 adapté pour recevoir par son antenne 41 des signaux radioélectriques haute fréquence pour fournir à sa sortie 42 des signaux basse fréquence. Ce récepteur 40 peut être de tout type connu, par exemple à super-réaction ou super-hétérodyne.

Ce récepteur 40 est soumis à un séquenceur 43, par exemple comprenant une horloge de séquencement, qui lui impose des phases temporellement espacées d'écoute ou de sensibilité, séparées par des phases d'inhibition ou d'absence d'écoute ou d'insensibilité. Dans un exemple particulier, ces phases temporellement espacées d'écoute ou de sensibilité du récepteur 40 peuvent être périodiques.

Le récepteur 40 se trouve être disposé à proximité d'un organe ou appareillage 44 électrique ou de traitement électronique, rayonnant un champ électromagnétique tel que le récepteur 40 est capable de détecter ou d'être sensible à ce champ électromagnétique rayonné, cet organe ou appareillage pouvant être l'un de ceux précédemment cités.

L'organe 44 est soumis à un séquenceur 45 qui comprend par exemple une horloge de séquencement et qui détermine des phases temporellement espacées de fonctionnement de cet organe 44, séparées par des phases de non fonctionnement, de telle sorte que cet organe 44 ne peut rayonner de champ électromagnétique que pendant ses phases de fonctionnement. Dans un exemple particulier, les phases de fonctionnement de l'organe rayonnant 44 peuvent être périodiques.

Les séquenceurs 43 et 45 sont soumis à un circuit de disjonction 46 qui permet de disjoindre temporellement les phases précitées d'écoute ou de sensibilité du récepteur 40 imposées par le séquenceur 43 par rapport aux phases précitées de fonctionnement de l'organe rayonnant 44 déterminées par le séquenceur 45.

Ainsi, d'une part le récepteur 40 est en phase d'écoute ou de sensibilité quand l'organe rayonnant 44 est à l'arrêt et d'autre part l'organe rayonnant 44 est en fonctionnement quand le récepteur 40 n'est pas en phase d'écoute ou de sensibilité, de telle sorte que le récepteur 40 ne détecte pas ou n'est pas sensible, en particulier sur sa fréquence nominale de réception, au champ électromagnétique de l'organe rayonnant 44.

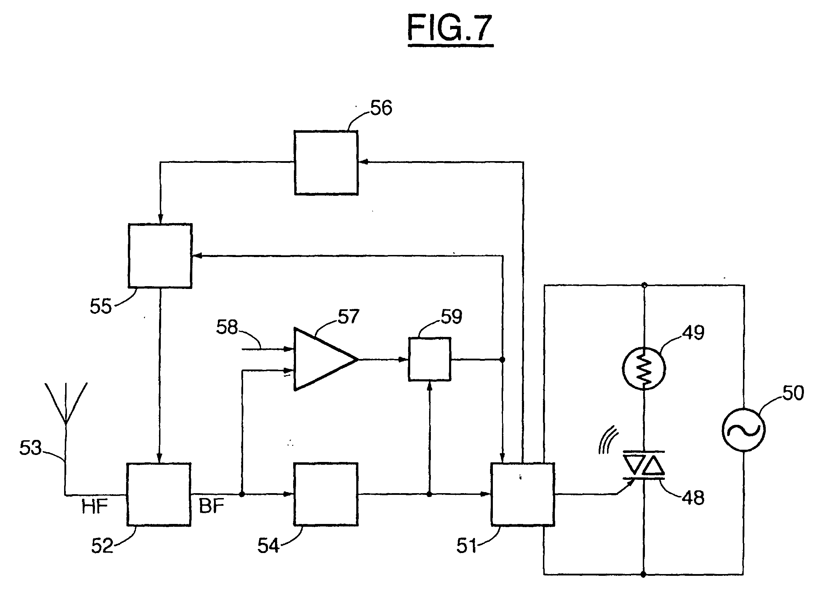

En se reportant à l'exemple de la figure 7, on va maintenant décrire un variateur, repéré d'une manière générale par la référence 47, par exemple un variateur de la lumière émise par une ampoule à incandescence ou un variateur de l'alimentation en énergie électrique d'une résistance de chauffage, télécommandée par des signaux radioélectriques.

Ce variateur 47 comprend un triac 48 monté en série avec une résistance de charge 49 aux bornes d'une source de courant électrique 50, par exemple le réseau électrique alternatif à 50 hertz.

Le triac 48 est soumis à un séquenceur de déclenchement 51 qui lui fournit des impulsions périodiques de déclenchement ou de fonctionnement en relation avec les périodes de la source d'énergie électrique 50.

Le variateur 47 comprend un récepteur 52, par exemple un récepteur super-hétérodyne ou à super-réaction, susceptible de recevoir des signaux radioélectriques par son antenne 53 et délivrant les signaux reçus, en basse fréquence, à un décodeur 54 dont la sortie des ordres est reliée au séquenceur 51 de déclenchement du triac 48.

Le récepteur 52 est soumis à un séquenceur 55 qui détermine des phases temporellement espacées de fonctionnement de ce récepteur 52.

Le séquenceur 51 délivre des impulsions de commande à un circuit de disjonction temporelle 56 dont la sortie est reliée au séquenceur 55.

La sortie des signaux basse fréquence BF du récepteur 52 est également reliée à un comparateur 57 dont l'autre entrée est reliée à un signal de référence 58. La sortie de ce comparateur est reliée à l'entrée d'un circuit de temporisation 59 qui reçoit en outre le signal de sortie du décodeur 54. La sortie de ce circuit de temporisation 59 est reliée à une entrée d'inhibition du séquenceur de déclenchement 51 et à une entrée de prolongation du séquenceur 55.

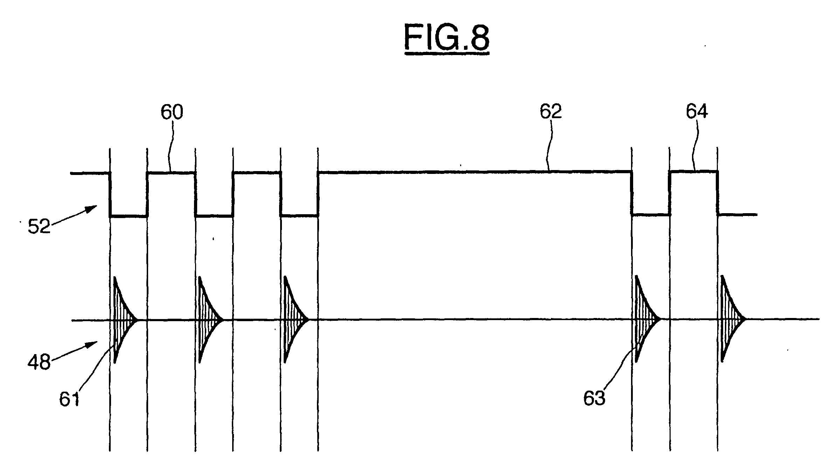

En référence à la figure 8, on va maintenant décrire comment fonctionne le variateur 47.

En l'absence de réception par le récepteur 52 d'un signal contenant un ordre à délivrer au séquenceur de déclenchement 51, ce séquenceur 51 fait fonctionner le triac 48 conformément à l'ordre qu'il a précédemment reçu et délivre au circuit de disjonction 56 des impulsions telles que le séquenceur 55 fait fonctionner le récepteur 52 selon des phases d'écoute ou de sensibilité 60 qui sont situées entre les phases 61 de rayonnement électromagnétique du triac 48 dues à ses impulsions périodiques de hachage du courant du réseau électrique, le récepteur 52 étant en conséquence inhibé pendant les phases 61 de rayonnement électromagnétique du triac 48 et en conséquence ne détectant pas ou n'étant pas sensible à ce rayonnement.

Si, pendant une phase d'écoute ou de sensibilité du récepteur 52, ce récepteur 52 reçoit un signal radioélectrique, le comparateur 57 compare le début de ce signal à un signal attendu 58. Si le début du signal reçu et ce signal attendu sont identiques, le comparateur 57 déclenche le circuit de temporisation 59 qui délivre un signal d'arrêt ou d'inhibition du séquenceur de déclenchement 51 pour bloquer ce dernier de façon à stopper le fonctionnement du triac 48 et, en même temps, délivre au séquenceur 55 un ordre de prolongation de la phase d'écoute ou de sensibilité du récepteur 52.

Lorsque le décodeur 54 a pu décoder le signal reçu et attendu pendant sa phase d'écoute ou de sensibilité prolongée 62, ce décodeur 54 délivre un ordre d'une part au circuit de temporisation 59 pour que le séquenceur 55 cesse la phase d'écoute ou de sensibilité prolongée 62, et d'autre part au séquenceur de déclenchement 51 qui peut alors faire fonctionner le triac 58 selon le contenu de l'ordre de commande reçu, par exemple une modification de la durée des périodes de ses impulsions de commande du triac 48. Le variateur 47 reprend alors son mode de fonctionnement décrit plus haut, modifié selon la périodicité nouvelle des phases de fonctionnement du triac 48, telle que pendant les phases de rayonnement électromagnétique du triac 48, le récepteur 52 est inhibé.

Par ailleurs, le circuit de temporisation 59 permet de limiter la durée des phases d'écoute ou de sensibilité prolongée 62 du récepteur 52 en fonction de la durée du signal radioélectrique de commande attendu au cas où le décodeur 54 ne pourrait interpréter en entier le signal radioélectrique reçu.

Ainsi, en l'absence d'un signal attendu, le séquenceur de déclenchement 51 impose les phases d'écoute ou de sensibilité du récepteur 52 tandis que pendant la réception d'un signal attendu, c'est le circuit de temporisation 59 qui s'impose par rapport au séquenceur 51.

La présente invention ne se limite pas aux exemples ci-dessus décrits. Bien des variantes de réalisation sont possibles sans sortir du cadre défini par les revendications annexées. En particulier, l'invention pourrait être par ailleurs appliquée uniquement à la partie fréquence intermédiaire ou d'amplification en bande de base de récepteurs à changement de fréquence.

## Revendications

1. Procédé de fonctionnement d'au moins un récepteur de signaux radioélectriques susceptible d'être disposé dans le champ électromagnétique d'au moins un moyen rayonnant d'un organe ou appareillage, en particulier un organe ou appareillage électrique, électronique ou électromécanique, à une distance telle que ledit récepteur est capable de détecter ou d'être sensible à ce champ électromagnétique rayonné notamment sur sa fréquence nominale de réception, **caractérisé par le fait qu'**il consiste :
- à soumettre ledit récepteur (25, 27, 30, 31, 35, 36, 40) à un signal d'horloge (21a) déterminant des phases séquentielles et/ou périodiques temporellement espacées d'écoute (22) ou de sensibilité (A),
- à soumettre ledit moyen rayonnant (28, 38, 44, 48) à un signal d'horloge (21a) déterminant des phases séquentielles et/ou périodiques temporellement espacées de fonctionnement ou de rayonnement,
- et à disjoindre temporellement les phases séquentielles et/ou périodiques d'écoute ou de sensibilité dudit récepteur par rapport aux phases séquentielles et/ou périodiques de fonctionnement ou de rayonnement dudit moyen rayonnant, en synchronisant le signal d'horloge du récepteur et le signal d'horloge du moyen rayonnant, de telle sorte que, pendant les phases d'écoute ou de sensibilité dudit récepteur, ledit moyen rayonnant est dans ses phases séquentielles et/ou périodiques de non fonctionnement ou de non rayonnement.

2. Procédé selon la revendication 1, dans lequel le récepteur (25, 30, 35) de signaux radioélectriques comprend une antenne (3), un oscillateur-détecteur (27, 31, 36) à super-réaction et des moyens (4) pour fixer des périodes (21a) composées de séquences de blocage-déblocage (23, 22) de cet oscillateur-détecteur afin de rendre sensible cet oscillateur-détecteur à l'énergie reçue sur une fréquence nominale de réception (f1), ledit oscillateur-détecteur présentant, dans chacune desdites périodes (21a), une phase de sensibilité (A) suivie d'une phase de montée en amplitude ou d'amplitude accrue (B, C) puis de décroissance (D) de ses oscillations, **caractérisé par le fait qu'**il consiste :
- à disjoindre temporellement la phase de sensibilité (A) de l'oscillateur-détecteur dudit récepteur par rapport à la phase de fonctionnement ou de rayonnement dudit moyen rayonnant en inhibant, bloquant ou stoppant le processus de fonctionnement ou de rayonnement dudit moyen rayonnant pendant la phase de sensibilité (A) de l'oscillateur-détecteur dudit récepteur.

3. Procédé selon la revendication 1, dans lequel le récepteur (25, 30, 35) de signaux radioélectriques comprend une antenne (3), un oscillateur-détecteur (27, 31, 36) à super-réaction et des moyens (4) pour fixer des périodes (21a) composées de séquences de blocage-déblocage (23, 22) de cet oscillateur-détecteur afin de rendre sensible cet oscillateur-détecteur à l'énergie reçue sur une fréquence nominale de réception (f1), ledit oscillateur-détecteur présentant, dans chacune desdites périodes (21a), une phase de sensibilité (A) suivie d'une phase de montée en amplitude ou d'amplitude accrue (B, C) puis de décroissance (D) de ses oscillations, **caractérisé par le fait qu'**il consiste :
- à détecter le rayonnement électromagnétique dudit moyen rayonnant ;
- et à disjoindre temporellement la phase de sensibilité (A) de l'oscillateur-détecteur dudit récepteur (25, 30, 35) par rapport à la phase de fonctionnement ou de rayonnement dudit moyen rayonnant (28, 38, 44) en décalant temporellement les phases précitées de fonctionnement ou de rayonnement dudit moyen rayonnant d'une valeur de temps prédéterminée.

4. Procédé selon la revendication 1, dans lequel le récepteur (25, 30, 35) de signaux radioélectriques comprenant une antenne (3), un oscillateur-détecteur (27, 31, 36) à super-réaction et des moyens (4) pour fixer des périodes (21a) composées de séquences de blocage-déblocage (23, 22) de cet oscillateur-détecteur afin de rendre sensible cet oscillateur-détecteur à l'énergie reçue sur une fréquence nominale de réception (f1), ledit oscillateur-détecteur présentant, dans chacune desdites périodes (21a), une phase de sensibilité (A) suivie d'une phase de montée en amplitude ou d'amplitude accrue (B, C) puis de décroissance (D) de ses oscillations, **caractérisé par le fait qu'**il consiste :
- à comparer (33) au moins une caractéristique des signaux radioélectriques reçus par ledit récepteur à une caractéristique correspondante d'un signal attendu (34),
- et à disjoindre temporellement la phase de sensibilité (A) de l'oscillateur-détecteur dudit récepteur par rapport à la phase de fonctionnement ou de rayonnement dudit moyen rayonnant (38) en fournissant auxdits moyens pour fixer des périodes (21a) composées de séquences de blocage-déblocage un ordre de décalage, d'une valeur de temps déterminée, desdites périodes (21a) au cas où ces caractéristiques comparées sont différentes.

5. Procédé selon la revendication 1, dans lequel ledit récepteur (25) et ledit moyen rayonnant sont deux récepteurs (25, 26) de signaux radioélectriques comprenant respectivement une antenne (3), un oscillateur-détecteur (27, 28) à super-réaction et des moyens (29) pour fixer des périodes (21a) composées de séquences de blocage-déblocage (23, 22) de cet oscillateur-détecteur afin de rendre sensible ces oscillateur-détecteur à l'énergie reçue sur une fréquence nominale de réception commune (f1) ou sur deux fréquences proches, lesdits oscillateurs-détecteurs présentant respectivement, dans chacune desdites périodes (21a), une phase de sensibilité (A) suivie d'une phase de montée en amplitude ou d'amplitude accrue (B, C) puis de décroissance (D) de ses oscillations, lesdits récepteurs étant susceptibles d'être disposés à une distance telle qu'au moins l'un desdits récepteurs est capable de détecter ou d'être sensible au champ électromagnétique susceptible d'être émis par l'autre, **caractérisé par le fait qu'**il consiste à disjoindre temporellement les phases de sensibilité (A) de l'oscillateur-détecteur (27) de l'un desdits récepteurs des phases précitées de montée en amplitude ou d'amplitude accrue (B, C) puis de décroissance (D) des oscillations de l'oscillateur-détecteur (28) de l'autre récepteur, en faisant osciller les oscillateurs-détecteurs (27, 28) desdits récepteurs selon des périodes (21a) composées de séquences de blocage-déblocage simultanées ou synchrones ou identiques, de telle sorte que l'un des récepteurs, pendant la phase de sensibilité de son oscillateur-détecteur, ne détecte pas l'énergie électromagnétique susceptible d'être rayonnée par l'autre récepteur sur ladite fréquence nominale ou lesdites fréquences proches.

6. Procédé selon la revendication 5, **caractérisé par le fait qu'**il consiste à soumettre les oscillateurs-détecteurs desdits récepteurs à une horloge commune (29) déterminant lesdites séquences d'oscillations de l'oscillateur-détecteur de ces récepteurs.

7. Procédé selon la revendication 1, **caractérisé par le fait qu'**il consiste :
- à comparer (33) au moins une caractéristique des signaux radioélectriques reçus par ledit récepteur (27, 31, 36, 40) à une caractéristique correspondante d'un signal attendu (34),
- et à disjoindre temporellement la phase d'écoute ou de sensibilité dudit récepteur par rapport à la phase de fonctionnement ou de rayonnement dudit moyen rayonnant(28, 38, 44) en décalant lesdites phases temporellement espacées d'écoute ou de sensibilité dudit récepteur, d'une valeur de temps déterminée, au cas où lesdites caractéristiques comparées sont différentes.

8. Procédé selon la revendication 1, **caractérisé par le fait qu'**il consiste :
- à soumettre ledit moyen rayonnant (28, 38, 44, 48) après réception par ledit récepteur (27, 31, 36, 40) d'un signal attendu à des phases temporellement espacées de fonctionnement ou de rayonnement,
- à comparer (57) au moins une caractéristique des signaux radioélectriques reçus par ledit récepteur à une caractéristique correspondante d'un signal attendu (58),
- et à disjoindre temporellement la phase d'écoute ou de sensibilité dudit récepteur par rapport à la phase de fonctionnement ou de rayonnement dudit moyen rayonnant en modifiant la durée desdites phases temporellement espacées d'écoute ou de sensibilité dudit récepteur et, corrélativement, à disjoindre lesdites phases de fonctionnement ou de rayonnement dudit moyen rayonnant, d'une valeur de temps déterminée, au cas où lesdites caractéristiques comparées sont identiques.

9. Procédé selon la revendication 8, **caractérisé par le fait qu'**il consiste à effectuer ladite modification de la durée desdites phases d'écoute ou de sensibilité dudit récepteur en prolongeant, d'une valeur de temps déterminée, la durée de la phase au cours de laquelle lesdites caractéristiques comparées sont identiques.

10. Procédé selon l'une des revendications 8 et 9, **caractérisé par le fait qu'**il consiste, après réception par ledit récepteur d'un signal attendu, à soumettre ledit moyen rayonnant (48) à des phases temporellement espacées de fonctionnement ou de rayonnement dépendant du contenu dudit signal reçu par ledit récepteur et à soumettre ledit récepteur à des phases temporellement espacées d'écoute ou de sensibilité dépendant également du contenu dudit signal reçu par ledit récepteur.

11. Procédé selon l'une quelconque des revendications 8 à 10, **caractérisé par le fait qu'**il consiste à soumettre ledit moyen rayonnant (48), tel qu'un triac, à des phases temporellement espacées de fonctionnement ou de rayonnement, ces phases consistant en des impulsions ou signaux périodiques de déclenchement ou de fonctionnement de ce moyen.

12. Procédé selon la revendication 11, **caractérisé par le fait que** lesdites impulsions sont en relation avec les périodes d'une source d'énergie électrique alternative.

## Patentansprüche

1. Verfahren zum Betrieb wenigstens eines Funkempfängers, der geeignet ist, um in einem elektromagnetischem Feld wenigstens eines strahlenden Mittels einer Einrichtung oder eines Geräts, insbesondere einer elektrischen, elektronische oder elektromechanischen Einrichtung oder eines solchen Geräts, in einem derartigen Abstand angeordnet zu werden, dass der Empfänger in der Lage ist, dieses insbesondere auf seiner Empfangsnennfrequenz ausgestrahlte elektromagnetische Feld zu detektieren oder empfindlich dafür zu sein, **dadurch gekennzeichnet, dass** zu dem Verfahren gehört:
- den Empfänger (25, 27, 30, 31 ,35, 36, 40) mit einem Taktsignal (21a) zu versorgen, das sequentielle und/oder periodische zeitlich voneinander beanstandete Empfangsphasen (22) oder Ansprechphasen (A) festlegt,
- das strahlende Mittel (28, 38, 44, 48) mit einem Taktsignal zu versorgen, das sequentielle und/oder periodische zeitlich voneinander beabstandete Betriebs- oder Abstrahlungsphasen festlegt,
- und die sequentiellen und/oder periodischen Empfangsphasen oder Ansprechphasen des Empfängers in Bezug auf die sequentiellen und/oder periodischen Betriebs- oder Abstrahlungsphasen des strahlenden Mittels zeitlich zu trennen, indem das Taktsignal des Empfängers und das Taktsignal des strahlenden Mittels derart synchronisiert werden, dass während der Empfangsphasen oder Ansprechphasen des Empfängers das strahlende Mittel sich in seinen sequentiellen und/oder periodischen Phasen des Nichtbetriebs oder der Abstrahlungsfreiheit befindet.

2. Verfahren nach Anspruch 1, bei dem der Funkempfänger (25, 30, 35) eine Antenne (3), einen Überlagerungsdetektor (27, 31, 36) mit Pendelrückkopplung sowie Mittel (4) aufweist, um Perioden (21a) zu definieren, die sich aus Folgen zum Sperren und Freigeben (23, 22) des Überlagerungsdetektors zusammensetzen, um den Überlagerungsdetektor für die auf seiner Empfangsnennfrequenz (f1) empfangene Energie empfindlich zu machen, wobei der Überlagerungsdetektor in jeder der Perioden (21a) eine Ansprechphase (A) gefolgt von einer Phase des Amplitudenanstiegs oder der vergrößerten Amplitude (B, C) und ferner eine Phase (D) des Abklingens seiner Schwinkungen aufweist, **dadurch gekennzeichnet, dass** zu dem Verfahren gehört:
- die Ansprechphase (A) des Überlagerungsdetektors des Empfängers in Bezug auf die Betriebs- oder Abstrahlungsphase des strahlenden Mittels zeitlich zu trennen, indem der Vorgang des Betriebs oder der Abstrahlung des strahlenden Mittels während der Ansprechphase (A) des Überlagerungsdetektors des Empfängers verhindert, gesperrt oder gestoppt wird.

3. Verfahren nach Anspruch 1, bei dem der Funkempfänger (25, 30, 35) eine Antenne (3), einen Überlagerungsdetektor (27, 31, 36) mit Pendelrückkopplung sowie Mittel (4) aufweist, um Perioden (21a) zu definieren, die sich aus Folgen des Sperrens und Freigebens (23, 22) des Überlagerungsdetektors zusammensetzen, um den Überlagerungsdetektor für die auf seiner Empfangsnennfrequenz (f1) empfangene Energie empfindlich zu machen, wobei der Überlagerungsdetektor in jeder der Perioden (21a) eine Ansprechphase (A) gefolgt von einer Phase des Amplitudenanstiegs oder der wachsenden Amplitude (B, C) und ferner eines Phase des Abklingens seiner Schwingungen (D) aufweist, **dadurch gekennzeichnet, dass** zu dem Verfahren gehört:
- die elektromagnetische Strahlung des strahlenden Mittels zu detektieren;
- und die Ansprechphase (A) des Überlagerungsdetektors des Empfängers (25, 30, 35) in Bezug auf die Betriebs- oder Abstrahlungsphase des strahlenden Mittels (28, 38, 44) zeitlich zu trennen, indem die vorgenannten Phasen des Betriebs oder der Abstrahlung des strahlenden Mittels um ein vorbestimmtes Zeitmaß verschoben werden.

4. Verfahren nach Anspruch 1, bei dem der Funkempfänger (25, 30, 35) eine Antenne (3), einen Überlagerungsdetektor (27, 31, 36) mit Pendelrückkopplung sowie Mittel (4) aufweist, um Perioden (21a) festzulegen, die aus Folgen zum Sperren und Freigebe (23, 22) des Überlagerungsdetektors gebildet sind, um den Überlagerungsdetektor für die auf einer Empfangsnennfrequenz (f1) empfangene Energie empfindlich zu machen, wobei der Überlagerungsdetektor in jeder der Perioden (21a) eine Ansprechphase (A), eine darauf folgende Phase des Amplitudenanstiegs oder der vergrößerten Amplitude (B, C) und ferner eine Phase des Abschwingens (D) aufweist, **dadurch gekennzeichnet, dass** zu dem Verfahren gehört:
- wenigstens eine Eigenschaft der durch den Empfänger empfangenen Funksignale mit einer entsprechenden Eigenschaft eines erwarteten Signals (35) zu vergleichen,
- und für den Fall, dass sich die verglichenen Eigenschaften voneinander unterscheiden, die Ansprechphase (A) des Überlagerungsdetektors des Empfängers in Bezug auf die Betriebs- oder Abstrahlungsphase des strahlenden Mittels (38) zeitlich zu trennen, indem an die Mittel zur Festlegung der Perioden (21a), die sich aus den Sperr- und Freigabefolgen zusammensetzen, ein Befehlssignal ausgegeben wird, um die Perioden (21a) um ein vorbestimmtes Zeitmaß zu verschieben.

5. Verfahren nach Anspruch 1, bei dem der Empfänger (25) und das strahlende Mittel (2) zwei Funkempfänger (25, 26) sind, die jeweils eine Antenne (3), einen Überlagerungsdetektor (27, 28) mit Pendelrückkopplung sowie Mittel (29) zur Festlegung von Perioden (21a) aufweisen, die sich aus Folgen des Sperrens und Freigebens (23, 22) des Überlagerungsdetektors zusammensetzen, um den Überlagerungsdetektor für die auf einer Empfangsnennfrequenz (f1) oder auf zwei benachbarten Frequenzen empfangene Energie empfindlich zu machen, wobei die Überlagerungsdetektoren jeweils in jeder der Perioden (21a) eine Ansprechphase (A) gefolgt von einer Phase des Amplitudenanstiegs oder der vergrößerten Amplitude (B, C) und ferner eine Phase des Abklingens ihrer Schwingungen (D) aufweisen, wobei die Empfänger geeignet sind, um in einem derartigen Abstand zueinander angeordnet zu werden, dass wenigstens einer der Empfänger in der Lage ist, die elektromagnetische Strahlung, die durch den anderen ausgesandt werden kann, zu detektieren, oder darauf anzusprechen, **dadurch gekennzeichnet, dass** zu dem Verfahren gehört, dass die Ansprechphasen (A) des Überlagerungsdetektors (27) eines der Empfänger von den vorgenannten Phasen des Amplitudenanstiegs oder der vergrößerten Amplitude (B, C) und ferner des Abschwingens (D) des Überlagerungsdetektors (28) des anderen Empfängers zeitlich voneinander getrennt werden, indem die Überlagerungsdetektoren (27, 28) der Empfänger entsprechend den Perioden (21a), die aus simultanen oder synchronen oder identischen Sperr- und Freigabesequenzen gebildet sind, derart schwingen gelassen werden, dass einer der Empfänger während der Ansprechphase seines Überlagerungsdetektors die von dem anderen Empfänger auf der Nennfrequenz oder den benachbarten Frequenzen ausstrahlbare elektromagnetische Energie nicht detektiert.

6. Verfahren nach Anspruch 5, **dadurch gekennzeichnet, dass** zu ihm gehört, die Überlagerungsdetektoren der Empfänger einem gemeinsamen Taktgeber (29) auszusetzen, der die Schwingungssequenzen der Überlagerungsdetektoren der Empfänger bestimmt.

7. Verfahren nach Anspruch 1, **dadurch gekennzeichnet, dass** zu ihm gehört:
- wenigstens eine Eigenschaft der durch den Empfänger (27, 31, 36, 40) empfangenen Funksignale mit einer entsprechenden Eigenschaft eines erwarteten Signals (34) zu vergleichen (33),
- und für den Fall, dass die verglichenen Eigenschaften sich voneinander unterscheiden, die Empfangsphase oder die Ansprechphase des Empfängers in Bezug auf die Betriebsphase oder Abstrahlungsphase des strahlenden Mittels (28, 38, 44) zeitlich zu trennen, indem die zeitlich getrennten Empfangsphasen oder Ansprechphasen des Empfängers um ein vorbestimmtes Zeitmaß verzögert werden.

8. Verfahren nach Anspruch 1, **dadurch gekennzeichnet, dass** zu ihm gehört:
- das strahlende Mittel (28, 38, 44, 48) nach dem Empfang eines erwarteten Signals durch den Empfänger (27, 31, 36, 40) zeitlich beabstandeten Betriebs- oder Abstrahlungsphasen zu unterwerfen,
- wenigstens eine Eigenschaft der durch den Empfänger empfangenen Funksignale mit einer entsprechenden Eigenschaft eines erwarteten Signals (58) zu vergleichen (57),
- und für den Fall, dass die verglichenen Eigenschaften identisch sind, die Empfangsphase oder Ansprechphase des Empfängers in Bezug auf die Betriebs- oder Abstrahlungsphase des strahlenden Mittels dadurch zeitlich zu trennen, dass die Dauer der zeitlich beabstandeten Empfangsphasen oder Ansprechphasen des Empfängers modifiziert wird, und, im Zusammenhang damit, die Phasen des Betriebs oder der Abstrahlung des strahlenden Mittels um ein vorbestimmtes Zeitmaß voneinander zu trennen.

9. Verfahren nach Anspruch 8, **dadurch gekennzeichnet, dass** es umfasst, die Modifikation der Dauer der Empfangsphasen oder Ansprechphasen des Empfängers dadurch zu bewirken, dass die Dauer der Phasen, während der die verglichenen Eigenschaften identisch sind, um ein vorbestimmtes Zeitmaß verlängert werden.

10. Verfahren nach einem der Ansprüche 8 und 9, **dadurch gekennzeichnet, dass** es umfasst, nach dem Empfang eines erwarteten Signals durch den Empfänger das strahlende Mittel (48) in Abhängigkeit von dem Inhalt des durch den Empfänger empfangenen Signals in zeitlich voneinander beabstandete Phasen des Betriebs oder der Abstrahlung zu versetzen und ebenfalls abhängig von dem Inhalt des durch den Empfänger empfangenen Signals den Empfänger in zeitlich voneinander beabstandete Empfangs- oder Empfindlichkeitsphasen zu versetzen.

11. Verfahren nach irgendeinem der Ansprüche 8 bis 10, **dadurch gekennzeichnet, dass** zu ihm gehört, das strahlende Mittel (48), beispielsweise ein Triac, in zeitlich voneinander beabstandete Phasen des Betriebs oder der Abstrahlung zu versetzen, wobei diese Phasen auf Impulssignalen oder periodischen Signalen zum Auslösen oder Betrieb dieses Mittels beruhen.

12. Verfahren nach Anspruch 11, **dadurch gekennzeichnet, dass** die Impulssignale mit der Frequenz einer Wechselstromquelle in Beziehung stehen.

## Claims

1. Method of operating at least one radio signal receiver that can be placed in the electromagnetic field of at least one radiating means of a member or apparatus, in particular an electrical, electronic or electromechanical member or apparatus, at a distance such that the said receiver is capable of detecting or of being sensitive to this radiated electromagnetic field, especially at its nominal receiving frequency, **characterized in that** it consists:
- in subjecting the said receiver (25, 27, 30, 31, 35, 36, 40) to a clock signal (21a) that determines temporally spaced-apart sequential and/or periodic receiving (22) or sensing (A) phases;
- in subjecting the said radiating means (28, 38, 44, 48) to a clock signal (21a) that determines temporally spaced-apart sequential and/or periodic operating or radiating phases; and
- in temporally separating the sequential and/or periodic receiving or sensing phases of the said receiver from the sequential and/or periodic operating or radiating phases of the said radiating means, by synchronizing the clock signal of the receiver with the clock signal of the radiating means, in such a way that, during the receiving or sensing phases of the said receiver, the said radiating means is in its sequential and/or periodic non-operating or non-radiating phases.

2. Method according to Claim 1, in which the radio signal receiver (25, 30, 35) comprises an antenna (3), a super-reaction oscillator-detector (27, 31, 36) and means (4) for fixing periods (21a) composed of sequences (23, 22) for turning this oscillator-detector on and off so as to make this oscillator-detector sensitive to the energy received at a nominal receiving frequency (f1), the said oscillator-detector having, in each of the said periods (21a), a sensing phase (A) followed by a phase (B, C) in which its oscillations rise in amplitude or have an increased amplitude and then a phase (D) in which its oscillations decrease, **characterized in that** it consists:
- in emporally separating the sensing phase (A) of the oscillator-detector of the said receiver from the operating or radiating phase of the said radiating means by inhibiting, blocking or stopping the operating or radiating process of the said radiating means during the sensing phase (A) of the oscillator-detector of the said receiver.

3. Method according to Claim 1, in which the radio signal receiver (25, 30, 35) comprises an antenna (3), a super-reaction oscillator-detector (27, 31, 36) and means (4) for fixing periods (21a) composed of sequences (23, 22) for turning this oscillator-detector on and off so as to make this oscillator-detector sensitive to the energy received at a nominal receiving frequency (f1), the said oscillator-detector having, in each of the said periods (21a), a sensing phase (A) followed by a phase (B, C) in which its oscillations rise in amplitude or have an increased amplitude and then a phase (D) in which its oscillations decrease, **characterized in that** it consists:
- in detecting the electromagnetic radiation of the said radiating means; and
- in temporally separating the sensing phase (A) of the oscillator-detector of the said receiver (25, 30, 35) from the operating or radiating phase of the said radiating means (28, 38, 44) by temporally shifting the aforementioned operating or radiating phases of the said radiating means by a predetermined amount of time.

4. Method according to Claim 1, in which the radio signal receiver (25, 30, 35) comprises an antenna (3), a super-reaction oscillator-detector (27, 31, 36) and means (4) for fixing periods (21a) composed of sequences (23, 22) for the turning-on/turning-off of this oscillator-detector on and off so as to make this oscillator-detector sensitive to the energy received at a nominal receiving frequency (f1), the said oscillator-detector having, in each of the said periods (21a), a sensing phase (A) followed by a phase (B, C) in which its oscillations rise in amplitude or have an increased amplitude and then a phase (D) in which its oscillations decrease, **characterized in that** it consists:
- in comparing (33) at least one characteristic of the radio signals received by the said receiver with a corresponding characteristic of an expected signal (34); and
- temporally separating the sensing phase (A) of the oscillator-detector of the said receiver from the operating or radiating phase of the said radiating means (38) by delivering, to the said means for fixing periods (21a) composed of turning-on/turning-off sequences, a command to shift, by a predetermined amount of time, the said periods (21a) should these compared characteristics be different.

5. Method according to Claim 1, in which the said receiver (25) and the said radiating means are two radio signal receivers (25, 26) comprising, respectively, an antenna (3), a super-reaction oscillator-detector (27, 28) and means (29) for fixing periods (21a) composed of sequences (23, 22) for turning this oscillator-detector on and off so as to make these oscillator-detectors sensitive to the energy received at a nominal common receiving frequency (f1) or at two nearby frequencies, the said oscillator-detectors having, respectively, in each of the said periods (21a), a sensing phase (A) followed by a phase (B, C) in which its oscillations rise in amplitude or have an increased amplitude and then a phase (D) in which its oscillations decrease, the said receivers being able to be placed at a distance such that at least one of the said receivers is capable of detecting or of being sensitive to the electromagnetic field liable to be emitted by the other one, **characterized in that** it consists in temporally separating the sensing phases (A) of the oscillator-detector (27) of one of the said receivers from the aforementioned phases (B, C) in which the oscillations of the oscillator-detector (28) of the other receiver rise in amplitude or have an increased amplitude and then a phase (D) in which the oscillations decrease, by making the oscillator-detectors (27, 28) of the said receivers oscillate with periods (21a) composed of turning-on/turning-off sequences which are simultaneous or synchronous or identical, in such a way that one of the receivers, during the sensing phase of its oscillator-detector, does not detect the electromagnetic energy liable to be radiated by the other receiver at the said nominal frequency or the said nearby frequencies.

6. Method according to Claim 5, **characterized in that** it consists in subjecting the oscillator-detectors of the said receivers to a common clock (29) that determines the said sequences of oscillations of the oscillator-detector of these receivers.

7. Method according to Claim 1, **characterized in that** it consists:
- in comparing (33) at least one characteristic of the radio signals received by the said receiver (27, 31, 36, 40) with a corresponding characteristic of an expected signal (34); and
- temporally separating the receiving or sensing phase of the said receiver from the operating or radiating phase of the said radiating means (28, 38, 44) by shifting the said temporally spaced-apart receiving or sensing phases of the said receiver by a predetermined amount of time should the said compared characteristics be different.

8. Method according to Claim 1, **characterized in that** it consists:
- in subjecting the said radiating means (28, 38, 44, 48), after an expected signal has been received by the said receiver (27, 31, 36, 40) to temporally spaced-apart operating or radiating phases;
- in comparing (57) at least one characteristic of the radio signals received by the said receiver with a corresponding characteristic of an expected signal (58); and
- temporally separating the receiving or sensing phase of the said receiver from the operating or radiating phase of the said radiating means by altering the duration of the said temporally spaced-apart receiving or sensing phases of the said receiver and, correspondingly, in separating the said operating or radiating phases of the said radiating means, by a predetermined amount of time should the said compared characteristics be identical.

9. Method according to Claim 8, **characterized in that** it consists in making the said alteration to the duration of the said receiving or sensing phases of the said receiver by extending, by a predetermined amount of time, the duration of the phase during which the said compared characteristics are identical.

10. Method according to either of Claims 8 and 9, **characterized in that** it consists, after an expected signal has been received by the said receiver, in subjecting the said radiating means (48) to temporally spaced-apart operating or radiating phases that depend on the content of the said signal received by the said receiver and in subjecting the said receiver to temporally spaced-apart receiving or sensing phases that also depend on the content of the said signal received by the said receiver.

11. Method according to any one of Claims 8 to 10, **characterized in that** it consists in subjecting the said radiating means (48), such as a triac, to temporally spaced-apart operating or radiating phases, these phases consisting of periodic pulses or signals for triggering or operating this means.

12. Method according to Claim 11, **characterized in that** the said pulses are in relationship with the periods of an AC power supply.
